# EUROPÄISCHE PATENTSCHRIFT

(11) **EP 1 445 799 B1**
(45) Veröffentlichungstag und Bekanntmachung des Hinweises auf die Patenterteilung: **09.05.2007**
(21) Anmeldenummer: 04002127.1
(22) Anmeldetag: 31.01.2004
(51) Int. Cl.: H01L 23/367

(54) **Kühleinrichtung für Halbleiter auf Leiterplatte**
Heat dissipation device for a semiconductor on a printed circuit board
Dispositif à dissipation de chaleur pour un semi-conducteur sur un circuit imprimé

(30) Priorität: 05.02.2003 DE 20301773 U
(43) Veröffentlichungstag der Anmeldung: 11.08.2004
(73) Patentinhaber: Leopold Kostal GmbH & Co. KG, 58507 Lüdenscheid (DE)
(72) Erfinder: Hütz, Uwe, 58566 Kierspe (DE); Rüggen, Christian, 44805 Bochum (DE)

(56) Entgegenhaltungen:
- WO-A-01/01738
- WO-A-99/11107
- DE-A1- 10 214 311
- DE-A1- 19 528 632
- GB-A- 2 124 035
- US-A- 5 014 904
- US-A- 5 923 084
- US-B1- 6 411 516

## Beschreibung

Die vorliegende Erfindung geht von einer gemäß dem Oberbegriff des Hauptanspruchs konzipierten elektrischen Einrichtung aus.

Derartige Einrichtungen sind dafür vorgesehen, um die von elektrischen Bausteinen - wie z.B. elektronischen Schaltelementen (Leistungshalbleiter) - erzeugte Wärmeenergie in ausreichendem Umfang von den Bausteinen abzuleiten und an die Umgebung abzuführen.

In diesem Zusammenhang ist beispielsweise durch die US-PS 5 014 904 eine die Merkmale des Oberbegriffs des Hauptanspruches aufweisende elektrische Einrichtung bekannt geworden, wobei ein elektrischer Baustein der einen Oberfläche einer Leiterplatte und ein damit über ein metallisches, in einem Durchbruch der Leiterplatte gehaltenes Verbindungselement gekoppelter Kühlkörper der von der einen Oberfläche abgewandten anderen Oberfläche der Leiterplatte zugeordnet ist.

Bei einer solchen Ausführungsform ist aber ein kompakter Aufbau der elektrischen Einrichtung nicht realisierbar und zwar, weil nicht beide Oberflächen der Leiterplatte zur Bestückung mit elektrischen/elektronischen Bauteilen vorgesehen sind.

Durch die US-Patentschrift 6,411,516 ist eine elektrische Einrichtung bekannt geworden, bei der ebenfalls ein in einem Durchbruch einer Leiterplatte aufgenommenes Verbindungselement zur Ableitung von Wärmeenergie von einem elektrischen Baustein zu einem zugeordneten Kühlkörper vorhanden ist. Das Verbindungselement wird dabei sowohl mit den beiden Seiten der Leiterplatte als auch mit dem elektrischen Baustein jeweils durch Lötprozesse verbunden.

Der vorliegenden Erfindung liegt deshalb die Aufgabe zugrunde, eine elektrische Einrichtung der eingangs erwähnten Art solchermaßen weiterzubilden, daß ein kompakter Aufbau derselben realisierbar und eine einfache Herstellung gewährleistet ist.

Erfindungsgemäß wird die Aufgabe durch die im kennzeichnenden Teil des Hauptanspruches angegebenen Merkmale gelöst.

Vorteilhaft bei einem derartigen Aufbau einer elektrischen Einrichtung ist, daß die am elektrischen Baustein entstehende Wärmeenergie zusätzlich auch über dem Verbindungselement zugeordnete Anteile der auf den beiden Oberflächen der Leiterplatte befindlichen Metallkaschierung abgeführt wird.

Weitere besonders günstige Ausgestaltungen der erfindungsgemäßen elektrischen Einrichtung sind in den Unteransprüchen angegeben und werden anhand eines in der Zeichnung dargestellten Ausführungsbeispieles näher erläutert.

Dabei zeigen:

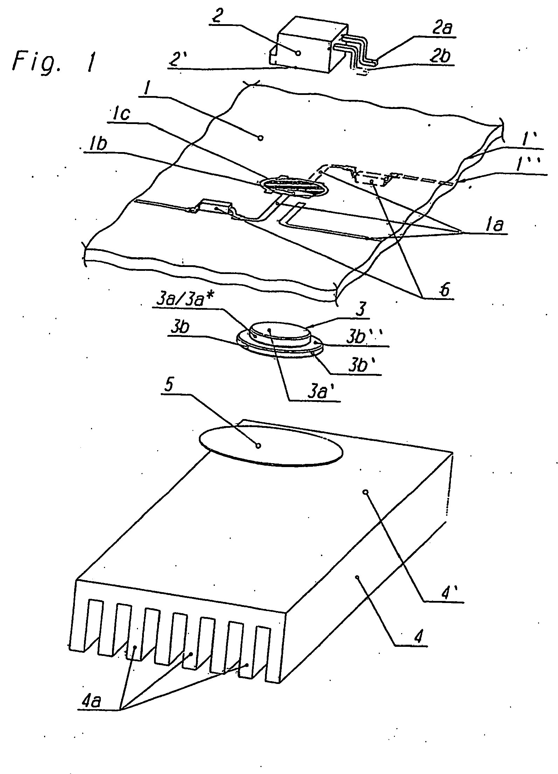

- Figur 1:: die elektrische Einrichtung in dreidimensionaler Darstellung.

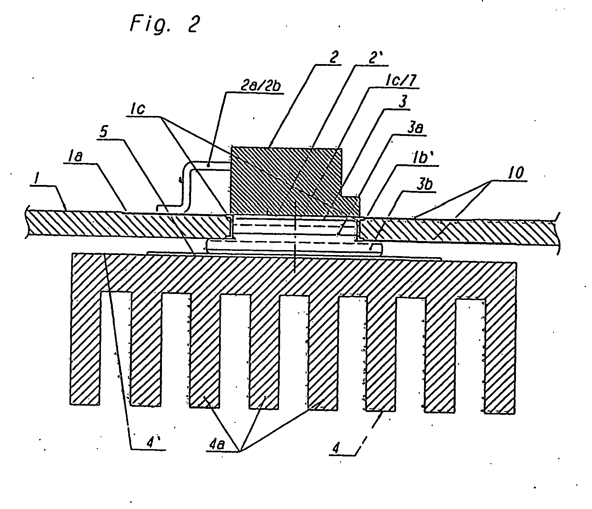

- Figur 2:: die elektrische Einrichtung nach Fig. 1 im Längsschnitt.

Wie aus der Zeichnung hervorgeht, weist die erfindungsgemäße elektrische Einrichtung als wesentliches Bestandteil eine nur ausschnittweise dargestellte metall kaschierte Leiterplatte 1 auf, die auf einer -1'- ihrer beiden Oberflächen 1',1" mit zumindest einem elektrischen/elektronischen Baustein 2 bestückt ist, welcher während seines Betriebes eine beachtliche Wärmeenergie entwickelt, die - um eine Zerstörung dieses Bausteines 2 zu vermeiden - an die Umgebung abzuführen ist.

Zu diesem Zweck ist der dargestellte elektrische Baustein 2 über-ein in einem Durchbruch 1b der Leiterplatte gehaltenes Verbindungselement 3 mit einem der anderen -1"- der beiden Oberflächen 1',1" der Leiterplatte 1 zugeordneten Kühlkörper 4 gekoppelt, d.h., die im elektrischen Baustein 2 bei dessen Betrieb entstehende Wärmeenergie wird vornehmlich über das Verbindungselement 3 dem Kühlkörper 4 unter Zwischenschaltung eines vorteilhafterweise als Wärmeleitfolie ausgebildeten Mittels 5 zugeführt und über dessen sehr-beachtliche, z.B. durch die Ausbildung von daran vorhandenen Kühlrippen 4a realisierte, relativ große Oberfläche an die Umgebung abgestrahlt. Zusätzlich wird die Wärmeenergie über das Verbindungselement 3 auf die zugeordneten, auf der anderen Oberfläche 1" der Leiterplatte vorhandenen Anteile 1a der Metallkaschierung übertragen, so daß eine weitere Wärmeabstrahlmöglichkeit geschaffen ist

Die Leiterplatte 1 ist dabei mit von Anteilen 1 a der auf der Leiterplatte 1 befindlichen Metallkaschierung gebildeten Leiterbahnen versehen, die sowohl auf der einen wie auf der anderen der beiden Oberflächen 1',1" der Leiterplatte 1 vorhanden sind und denen elektrische/elektronische Schaltungskomponenten 6 zugeordnet sind. Weiterhin sind einige der Leiterbahnen bis zu dem in der Leiterplatte 1 angeordneten, als kreisförmige Bohrung ausgeführten Durchbruch 1b geführt, dessen Wandung 1b' und dessen beide der einen und der anderen Oberfläche 1',1" der Leiterplatte 1 zugeordnete Ränder mit einer elektrisch gut leitfähigen, duktilen Metallschicht 1c im Sinne einer sogenannten Durchkontaktierung versehen sind. Mit dieser Metallschicht 1c steht das mit einer sehr duktilen Metallschicht stoffschlüssig überzogene, aus einem duktilen Metall hergestellte und zwar insbesondere aus einem verzinnten Kupferkern bestehende profilierte Verbindungselement 3 durch einen Einpreßvorgang form- und kraftschlüssig in Eingriff, so daß neben einer guten mechanischen Verbindung auch eine einwandfreie elektrische Verbindung zustande kommt.

Das profilierte Verbindungselement 3, d.h., es ist als abgestufter kreiszylindrischer Körper mit zwei stufen mit unterschiedlichen Dürchmessern ausgebildet, ist dabei derart im Durchbruch 1 b angeordnet, daß ein im Durchmesser klein ausgeführter, vorteilhafterweise mit einer einen einwandfreien Preßsitz im Durchbruch 1b gewährleistenden, insbesondere durch eine Riffelung realisierten strukturierten Oberfläche 3a* versehener erster Bereich 3a im Durchbruch 1b gehalten ist, während ein im Durchmesser größer ausgebildeter zweiter Bereich 3b mit seiner ringförmigen Anlagefläche 3b" der einen -1"- der-beiden Oberflächen 1',1" der Leiterplatte 1 und mit seiner kreisförmigen Stützfläche 3b' der Kopffläche 4' des Kühlkörpers 4 über die auch eine elektrische isolation zwischen dem Verbindungselement 3 und dem Kühlkörper 4 gewährleistende Wärmeleitfolie 5 zugeordnet ist.

Über die ringförmige Anlagefläche 3b" des Verbindungselementes 3 ist somit sowohl eine elektrische als auch eine wärmeleitfähige Verbindung zu der auf der anderen Oberfäche 1' der Leiterplatte 1 befindlichen Metallkaschierung realisiert, so daß neben der elektrischen Verbindung zu den auf dieser anderen Oberfläche 1' befindlichen Schaltungskomponenten 6 auch eine wärmeleitende Verbindung mit der auf der anderen Oberfläche 1' befindlichen Metallkaschierung zustande kommt, so daß die am elektrischen Baustein 2 entstehende Wärme nicht nur über den Kühlkörper 4 sondern auch über die Metallkaschierung 1 a der Leiterplatte 1 abgeführt wird.

Mit dem elektrischen Baustein 2 ist das Verbindungselement 3 stoffschlüssig durch zwischen der Kopffläche 3a' des Verbindungselementes 3 und der Stützfläche 2' des elektrischen Bausteines befindliches Lotmaterial 7 verbunden, das in einen zwischen diesen beiden Flächen vorhandenen Spalt 1c' eingebracht ist und somit auch zur elektrischen Verbindung der miteinander kooperierenden Komponenten beiträgt.

Die elektrische Verbindung des Bausteines 2 zu den zugehörigen, als Leiterbahnen ausgebildeten Anteilen 1a der Metallkaschierung erfolgt über dem elektrischen Baustein 2 zugehörige Anschlußfahnen 2a,2b welche mit den damit kooperierenden Anteilen 1a der Metallkaschierung verlötet sind. Vorteilhaft in diesem Zusammenhang ist, wenn die miteinander kooperierenden Komponenten der elektrischen Einrichtung als sogenannte SMD-Bauteile ausgebildet sind, wobei die Verlötung über auf die zu verlötenden Stellen der Leiterplatte 1 aufgetragene Lötpaste durch einen Reflow-Prozeß erfolgt.

## Patentansprüche

1. Elektrische Einrichtung mit einer metallkaschierten Leiterplatte (1), der ein auf einer (1') ihrer beiden Oberflächen (1',1") angeordneter, an von Anteilen (1a) der Metallkaschierung gebildeten Leiterbahnen der Leiterplatte (1) angeschlossener, Wärmeenergie abgebender elektrischer Baustein (2) zugeordnet ist, der über ein in einem mit einer an seiner Wandung (1 b') vorhandenen duktilen Metallschicht (1c) versehenen Durchbruch (1b) der Leiterplatte (1) form- und kraftschlüssig gehaltenes metallisches Verbindungselement (3) mit einem auf der anderen (1") der beiden Oberflächen (1',1") der Leiterplatte (1) angeordneten Kühlkörper (4) über ein wärmeleitendes Mittel (5) gekoppelt ist, **dadurch gekennzeichnet, daß** die in dem Durchbruch (1 b) vorhandene duktile Metallschicht (1c) zur elektrischen Verbindung von auf beiden Oberflächen (1',1") der Leiterplatte (1) angeordneten Anteilen (1a) der Metallkaschierung vorgesehen ist und mit einer am Verbindungselement (3) vorhandenen, strukturierten Oberfläche (3a*) in mechanischem Eingriff steht, die an einem dem Durchbruch (1b) zugeordneten (ersten) Bereich (3a) des Verbindungselementes (3) ausgebildet ist.

2. Elektrische Einrichtung nach Anspruch 1, **dadurch gekennzeichnet, daß** das metallische Verbindungselement (3) als abgestufter kreiszylindrischer Körper mit zwei Stufen mit unterschiedlichen Durchmessern ausgebildet ist.

3. Elektrische Einrichtung nach einem der Ansprüche 1 oder 2, **dadurch gekennzeichnet, daß** das metallische Verbindungselement (3) aus einem verzinnten Kupferkern besteht.

4. Elektrische Einrichtung nach einem der Ansprüche 1 bis 3, **dadurch gekennzeichnet, daß** das metallische Verbindungselement (3) in einem dem als Bohrung ausgeführten Durchbruch (1b) der Leiterplatte (1) zugeordneten ersten Bereich (3a) einen gegenüber der Ausdehnung des kreisförmigen Durchbruchs (1b) geringfügig größeren kreisförmigen Querschnitt aufweist und in dieselbe eingepreßt ist.

5. Elektrische Einrichtung nach einem der Ansprüche 1 bis 4, **dadurch gekennzeichnet, daß** das metallische Verbindungselement (3) an seinem dem Kühlkörper (4) zugewandten Ende eine plane Stützfläche (3b') aufweist und mit derselben über eine das wärmeleitende Mittel (5) bildende Wärmeleitfolie mit einer ebenfalls planen Kopfzone (4') des Kühlkörpers (4) verbunden ist.

6. Elektrische Einrichtung nach Anspruch 5, **dadurch gekennzeichnet, daß** das eine elektrische Isolation des Verbindungselementes (3) zum Kühlköper (4) bewirkende, als Wärmeleitfolie ausgebildete Mittel (5) eine Ausdehnung aufweist, die größer als die Ausdehnung der an dem dem vorzugsweise aus Metall hergestellten Kühlkörper (4) zugewandten Ende des Verbindungselementes (3) vorhandenen Stützfläche (3b') ist.

7. Elektrische Einrichtung nach einem der Ansprüche 1 bis 6, **dadurch gekennzeichnet, daß** das metallische Verbindungselement (3) über auf eine an seinem dem elektrischen Baustein (2) zugeordneten Ende vorhandene plane Kopffläche (3a') aufgetragenes Lotmaterial (7) mit dem eine entsprechende Stützfläche (2') aufweisenden elektrischen Baustein (2) elektrisch leitend verbunden ist.

8. Elektrische Einrichtung nach Anspruch 7, **dadurch gekennzeichnet, daß** der elektrische Baustein (2) als sogenanntes SMD-Bauelement ausgebildet ist und daß der erste Bereich (3a) des metallischen Verbindungselementes (3) eine derartige Höhe aufweist, daß ein mit dem auch eine stoffschlüssige Verbindung zu der der Wandung (1b') zugeordneten Metallschicht (1c) gewährleistenden Lotmaterial (7) aufzufüllender Spalt (1b') zwischen der planen Kopffläche (3a') des Verbindungselementes (3) und der Stützfläche (2') des direkt auf der einen Oberfläche (1a) der Leiterplatte (1) zur Abstützung gelangenden elektrischen Bausteines (2) in dem Durchbruch (1b) der Leiterplatte (1) vorhanden ist.

## Claims

1. Electrical apparatus with a metal-laminated printed circuit board (1) to which is allocated an electrical module (2) which is arranged on the first (1') of its two surfaces (1',1") and releases thermal energy and is connected to strip conductors of the printed circuit board (1) formed by portions (1 a) of the metal lamination and which is coupled by way of a heat-conductive medium (5) to a dissipater (4) arranged on the second (1") of the two surfaces (1',1") of the printed circuit board (1) by means of a metallic bonding element (3) held in a form-fit, non-positive manner in a cut-out (1b) of the printed circuit board (1) whose sides (1b') are provided with a ductile metal coating (1c), **characterised by** the fact that the ductile metal coating (1c) provided in the cut-out (1b) is intended for the purpose of electrically connecting portions (1a) of the metal lamination arranged on both surfaces (1',1") of the printed circuit board (1) and engages mechanically with a structured surface (3a*) which is provided on the bonding element (3) and shaped on a (first) zone (3a) of the bonding element (3) allocated to the cut-out (1b).

2. Electrical apparatus in accordance with Claim 1, **characterised by** the fact that the metallic bonding element (3) is designed as a graded regular cylindrical body with two steps of different diameters.

3. Electrical apparatus in accordance with Claim 1 or Claim 2, **characterised by** the fact that the metallic bonding element (3) consists of a tin-plated copper core.

4. Electrical apparatus in accordance with any of Claims 1 to 3, **characterised by** the fact that, in a first zone (3a) allocated to the cut-out (1b) executed as a bore in the printed circuit board (1), the metallic bonding element (3) shows a slightly larger circular cross-section in comparison to the dimension of the circular cut-out (1b) and is pressed into the same.

5. Electrical apparatus in accordance with any of Claims 1 to 4, **characterised by** the fact that the metallic bonding element (3) shows a flat supporting surface (3b') on its end facing the dissipater (4) and is connected with the same to a likewise flat head zone (4') of the dissipater (4) by way of a heat conductive foil constituting the heat-conductive medium (5).

6. Electrical apparatus in accordance with Claim 5, **characterised by** the fact that the medium (5), which is designed as a heat conducting foil and effects an electrical insulation between the bonding element (3) and the dissipater (4), shows a dimension which is larger than the dimension of the supporting area (3b') provided on the end of the bonding element (3) facing towards the dissipater (4), which is preferably made of metal.

7. Electrical apparatus in accordance with any of Claims 1 to 6, **characterised by** the fact that the metallic bonding element (3) is connected to the electrical module (2) in an electrically conductive manner by way of a soldering material (7) applied to a flat head zone (3a') provided on its end which is allocated to the electrical module (2) and features an appropriate supporting surface (2').

8. Electrical apparatus in accordance with Claim 7, **characterised by** the fact that the electrical module (2) is designed as a so-called SMD component and that the first zone (3a) of the metallic bonding element (3) shows such a height that in the cut-out (1b) of the printed circuit board (1) there is a gap (1b') between the flat head zone (3a') of the bonding element (3) and the supporting surface (2') of the electrical module (2) that reaches directly onto the one surface (1a) of the printed circuit board (1) for support, wherein the gap (1b') is to be filled with the soldering material (7) to additionally warrant the bonded connection to the metal coating (1c) allocated to the side wall (1b').

## Revendications

1. Dispositif électrique avec une plaquette de circuits imprimés (1) pourvue d'un revêtement métallique, à laquelle est associé un élément constitutif électrique (2) dégageant de l'énergie thermique, agencé sur l'une (1') de ses deux surfaces (1', 1") et raccordé à des pistes conductrices de la plaquette de circuits imprimés (1) formées par des portions (1a), qui, par l'intermédiaire d'un élément de connexion métallique (3) maintenu par emboîtement et par friction dans un évidement (1b) de la plaquette de circuits imprimés (1) pourvu sur sa paroi (1b') d'une couche métallique ductile (1c) est couplé par l'intermédiaire d'un moyen conducteur de chaleur (5) avec un dissipateur thermique (4), disposé sur l'autre (1") des deux surfaces (1', 1") de la plaquette de circuits imprimés (1), **caractérisé en ce que** la couche métallique ductile (1c) prévue dans le l'évidement (1b) est prévue pour la connexion électrique de portions (1a) du revêtement métallique appliqué sur les deux surfaces (1', 1") de la plaque de circuits imprimés (1) et est en prise avec une surface structurée (3a*) de l'élément de connexion (3) qui est réalisée dans une (première) section (3a) de l'élément de connexion (3), associée à l'évidement (1b).

2. Dispositif électrique selon la revendication 1, **caractérisé en ce que** l'élément de connexion métallique (3) est conçu en tant que pièce cylindrique circulaire étagée avec des gradins présentant des diamètres différents.

3. Dispositif électrique selon revendication 1 ou 2, **caractérisé en ce que** l'élément de connexion métallique (3) consiste en un noyau de cuivre étamé.

4. Dispositif électrique selon l'une des revendications 1 à 3, **caractérisé en ce que** l'élément de connexion métallique (3) présente, dans une première zone (3a), associée à l'évidement (1b) de la plaque de circuits imprimés (1), réalisé en tant qu'alésage, une section transversale circulaire légèrement plus grande que l'étendue de l'évidement (1b) circulaire, et est pressé dans celle-ci.

5. Dispositif électrique selon l'une des revendications 1 à 4, **caractérisé en ce que** l'élément de connexion métallique (3) présente à son extrémité orientée vers le dissipateur thermique (4) une surface d'appui (3b') plane et est relié avec celle-ci par l'intermédiaire d'une feuille conductrice de chaleur formant le moyen de conduction de chaleur (5) avec une zone de tête (4') également plane du dissipateur thermique (4).

6. Dispositif électrique selon la revendication 5, **caractérisé en ce que** le moyen (5), conçu en tant que feuille conductrice de chaleur, assurant une isolation électrique entre l'élément de connexion (3) et le dissipateur thermique (4), présente une étendue qui est plus grande que l'étendue que la surface d'appui (3b'), présente à l'extrémité de l'élément de connexion (3) orientée vers le dissipateur thermique (4), fabriqué préférentiellement en métal.

7. Dispositif électrique selon l'une des revendications 1 à 6, **caractérisé en ce que** l'élément de connexion métallique (3) est reliée, au moyen d'une matière de brasage (7), appliquée sur une surface de tête (3a') plane, présente à son extrémité associée à l'élément constitutif électrique (2), à un élément constitutif électrique (2) présentant une surface de support (2') correspondante,.

8. Dispositif électrique selon la revendication 7, **caractérisé en ce que** l'élément constitutif électrique (2) est conçu en tant que module dit SMD, et **en ce que** la première zone (3a) de l'élément de connexion métallique (3) présente une hauteur telle qu'une fente (1 b'), devant être remplie avec la matière de brasage (7) assurant aussi une liaison de matière par rapport au revêtement métallique (1c) associé à la paroi (1b'), existe, dans l'évidement (1b) de la plaquette de circuits imprimés (1), entre la surface de tête (3a') plane de l'élément de connexion (3) et la surface de support (2') de l'élément constitutif électrique (2) venant prendre appui directement sur l'une (1a) des surfaces de la plaquette de circuits imprimés (1).
